Europäisches Patentamt

European Patent Office

Office Européen des brevets

(19)

(11) Publication number: **0 209 390 B1**

# EUROPEAN PATENT SPECIFICATION

(12)

(45) Date of publication of patent specification :
02.01.91 Bulletin 91/01

(51) Int. Cl.⁵ : **H05K 13/04**

(21) Application number : **86305518.2**

(22) Date of filing : **17.07.86**

(54) Apparatus for continuous processing in directions of x- and y- Co-Ordinates.

(30) Priority : **18.07.85 JP 157056/85**

(43) Date of publication of application :
**21.01.87 Bulletin 87/04**

(45) Publication of the grant of the patent :
**02.01.91 Bulletin 91/01**

(84) Designated Contracting States :
**FR GB IT**

(56) References cited :
**EP-A- 0 184 943**
**DE-A- 3 435 507**
**FR-A- 1 366 277**
**US-A- 3 718 800**

(73) Proprietor : **Hy-Bec Corporation**
**Yasuda Building 2-15-14 Tsukiji**
**Chuo-ku Tokyo (JP)**

(72) Inventor : **Hayakawa, Futomi c/o Hy-Bec**
**Corporation**
**2-15-14 Tsukiji**
**Chuo-ku Tokyo (JP)**
Inventor : **Onoda, Kazuo c/o Hy-Bec**
**Corporation**
**2-15-14 Tsukiji**
**Chuo-ku Tokyo (JP)**

(74) Representative : **Ayers, Martyn Lewis Stanley**
**et al**
**J.A. KEMP & CO. 14 South Square Gray's Inn**
**London, WC1R 5EU (GB)**

# Description

The present invention relates to an apparatus for continuous processing in the directions of x- and y-co-ordinates, suitable especially for soldering a work piece or semiconductor device, such as, IC-, LSI-chip of the like, on a substrate plate, wherein the distance between a pair of parallel linear sections to be processed (processing lines) and the length of the processing line are different in the directions of x- and y-co-ordinates.

For soldering terminal pins of semiconductor devices, such as, IC- and LSI-chips, with those of a substrate, there have been in practical use non-contact type apparatuses, in which a laser beam transmitted through a flexible light conducting filament (optical fiber) is employed to spot irradiate the soldering site to each lead pin of the semiconductor chip with corresponding pin of the substrate, and contact type apparatuses, in which the soldering is effected by using a soldering iron contacting the soldering spot directly.

The non-contact type soldering apparatuses are costly, since expensive optical elements and devices are required, such as, optical fiber, etc. The irradiation of a soldering spot by a laser beam may sometimes burn the substrate or destroy the semiconductor chip during the processing work because of the high temperature resulting from the irradiation by the laser beam.

A contact type soldering apparatus may produce a defective connection in the processed site due to the flux material, contaminants adhering on the soldering iron and so on, so that it is necessary to remove the contaminants and to polish the soldering iron tip in frequent intervals.

In particular, several types of soldering iron tip are needed since it has been necessary to change or replace the soldering iron tip in accordance with the alteration of the type and form of the semiconductor chip to be processed. In addition, in the case of contact type apparatuses, continuous processing in directions of x- and y- co-ordinates is not possible when the distance between the processing lines or the length thereof is different in the directions of x- and y- co-ordinates, since it is necessary to let the iron tip contact with each processing site.

According to the present invention there is provided apparatus for processing a work piece by irradiating a pair of coplanar parallel processing lines with heat rays characterised in that it comprises : heat ray source means mounted on a heat ray source assembly and means for focussing the heat rays into lines on said processing lines ; means for moving the work piece and heat ray source means towards and away from each other so as to bring the work piece into and out of the focus of the heat rays and to effect relative rotation of the heat ray source means and work piece to allow the processing of further processing lines extending in different directions to the first mentioned processing lines ; means for adjusting the distance between the parallel line foci of the heat rays ; and an adjustable masking element disposed between the heat ray source means and the work piece to vary the width of the beam of heat rays thereby to determine the length of the line focus of the heat rays.

In more detail the present invention provides an apparatus for processing a work piece, characterised in that it comprises a pair of heat ray sources, arranged on a heat ray source assembly, for irradiating a pair of parallel processing lines by focussing heat rays into lines along said processing lines, said heat ray source assembly being rotatable so as to allow said line foci to be aligned with processing lines extending in a different direction to the first lines, a cylinder/piston arrangement for effecting vertical positioning of said pair of heat ray sources for adjusting the focussing of the heat rays onto said processing line, a distance adjusting means for adjusting the distance between said pair of parallel line foci by effecting a relative shifting of said pair of heat ray sources, a masking element provided for each heat ray source and comprising a shield member for defining the width of the heat ray beam leaving the heat ray source and thereby determining the length of the line focus and masking element actuating means provided for each of said pair of heat ray sources and comprising at least one cylinder/piston unit for effecting shifting of said shield member to vary the width of the heat ray beam and thus to vary the length of the line focus.

The present invention therefore allows continuous processing of a work piece by continuous and successive soldering along pairs of soldering lines in different directions, even when the distance between the pairs of parallel processing lines and the length thereof are different in the different directions.

The fact that the heat ray beam is concentrated or focussed onto the processing line in a prolonged focus (denoted hereinafter as line focus) in a form of a segment of a line having a length corresponding to that of the processing line, means that little extraneous heat will irradiate the portion other than the processing line.

Furthermore the distance between the pair of line focuses of heat ray beams irradiating the pair of processing lines and the length of the line focus may be automatically adjusted during the time interval after the finish of the processing of the first lines till the commencement of the processing of the further lines, whereby the total processing time for one complete cycle of processing effected in both the directions can be decreased.

The pair of heat ray sources are assembled on a heat ray source assembly which may be rotated, in order that the processing, for example, soldering, of processing lines extending in an x- co-ordinate direction may be automatically succeeded by processing in a y- co-ordinate direction. Thus, the soldering of a pair of processing lines in the direction of x- co-ordinate is first carried out by a pair of heat ray beams, each of which is focussed onto the processing line, e.g. a soldering line in which a row of terminal lead pins of the semiconductor chip and a row of corresponding terminal lead pins on the substrate plate are aligned, and thereafter the soldering of a pair of processing lines in the direction of y- co-ordinate is effected by turning round the heat ray source assembly through an angle of 90°. In order to allow the distance between the pair of line foci to coincide with the distance between the pair of processing lines not only in the x- direction but also in the y- direction, said pair of heat ray sources are subjected to a parallel shifting while holding a constant orientation toward each of the processing lines, e.g. at a constant angle to the processing line. On the other hand, the adjustment of the length of line focus irradiating the processing line for the processing in x- direction and for the processing in y- direction is attained in such a manner, that a pair of automatically slidable shield members are disposed on each heat ray discharge opening of the heat ray source. Thus, even when the work piece to be processed has different processing lengths in x- and y-directions, an automatic adjustment of the line focus not only in the distance between the pair of line foci but also in the length of each line focus can be attained. Therefore, there is no limitation in the size and type of work piece and a reduction in the total processing time required for complete cycle of processing work including processing steps in x- and y- directions is achieved, so that the work performance is markedly improved. By the automatic succession from the processing step of x- direction to that of y- direction by turning round the heat ray source assembly through a right angle, the work piece need be postioned once only on the work table and then can be processed automatically in both the x- and y- directions in a continuous manner.

The invention will be further described by way of non-limitative example with reference to the accompanying drawings in which :

Figure 1 is an exemplary representation of an arrangement of an IC-chip on a substrate for processing by soldering, in a schematic plan view ;

Figure 2 shows an embodiment of the apparatus according to the invention in a front view ;

Figure 3 is a side view of the apparatus of Figure 2 ;

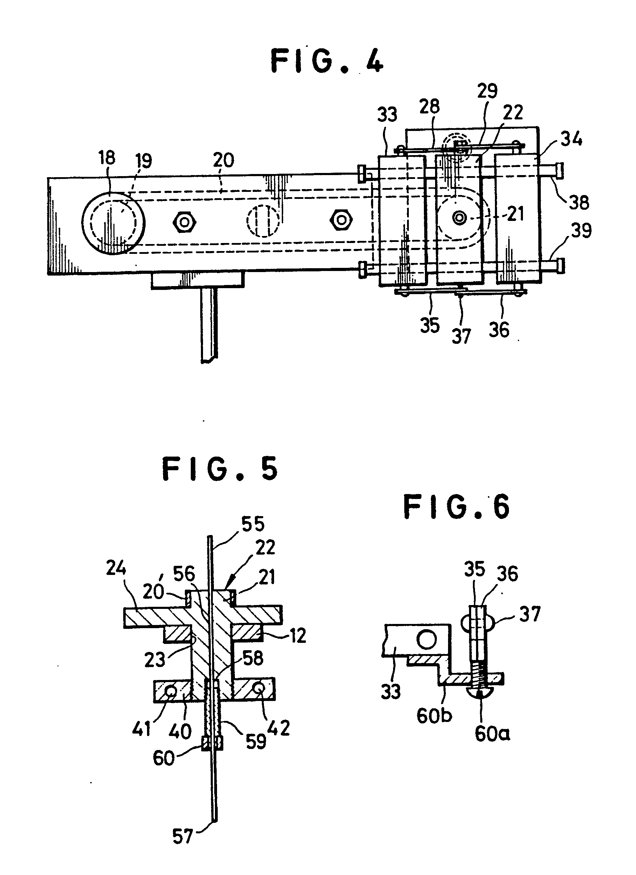

Figure 4 is the underside plan of the apparatus of Figure 2 ;

Figure 5 is a vertical section through the rotatable shaft of the heat ray source assembly of the apparatus of Figure 2 ;

Figure 6 illustrates one end portion of the slide member of the heat ray source assembly in an enlarged vertical section ;

Figure 7(A) shows the focussing of heat ray beams onto the soldering lines ;

Figure 7(B) is a diagram of relationship between the minimum interval of the pair of line focuses and the outer diameter of the centering collar ;

Figure 8 illustrates the structure of the masking mechanism for the heat ray irradiation ;

Figure 9 is a section of heat ray source ;

Figure 10 is a perspective view of the shield member ;

Figure 11 is a side view of the heat ray source ;

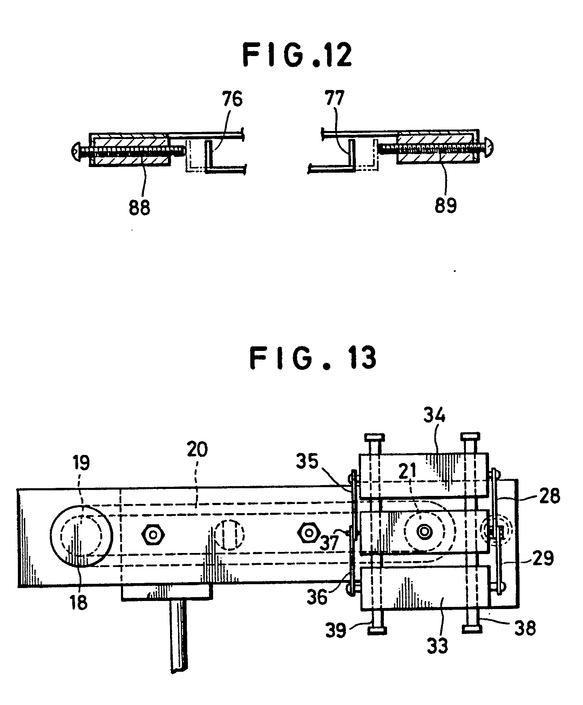

Figure 12 is a partial section of the masking element showing the manner of adjustment of the masking width ; and

Figure 13 is an underside plan of the apparatus of Figure 2 in which the heat ray source assembly has been turned throug 90° by the turning element.

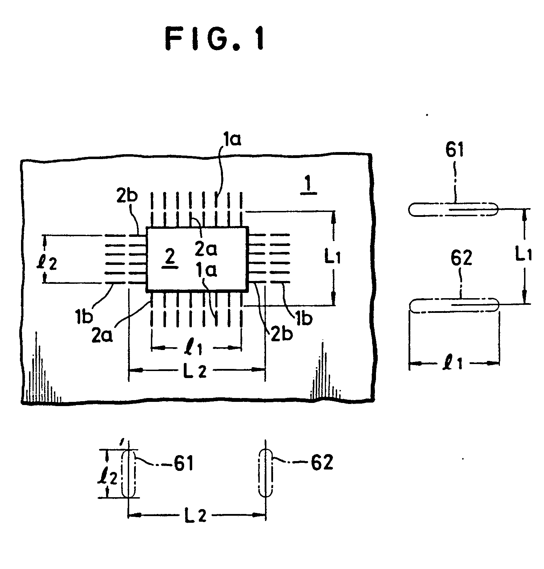

Figure 1 shows an arrangement of a semiconductor device 2, such as IC- or LST-chip, on a substrate for processing by soldering in plan view. The semiconductor chip 2 is provided with a number of terminal lead pins 1a, 1b in alignment with the corresponding terminal lead pins 2a, 2b of the substrate plate 1. The work piece held in this orientation is set on a work table (not shown). The relationship betwen the distance $L_1$ of the two parallel processing lines extending in the direction of x- co-ordinate and the distance $L_2$ of the two parallel processing lines extending in the direction of y- co-ordinate in this embodiment of Figure 1 is $L_1 < L_2$. Thus, a pair of processing lines in the x- direction are irradiated by a corresponding pair of heat ray beams focussed in a line focus having a length of $1_1$ apart. In a similar way, the processing in the y-direction is performed by a pair of heat ray beams focussed onto the corresponding pair of processing lines extending in y- direction as line foci having length $1_z$ corresponding to the length of the processing line and a distance $L_2$ aparat. An embodiment of an apparatus capable of realising the processing in the manner as above will be explained below.

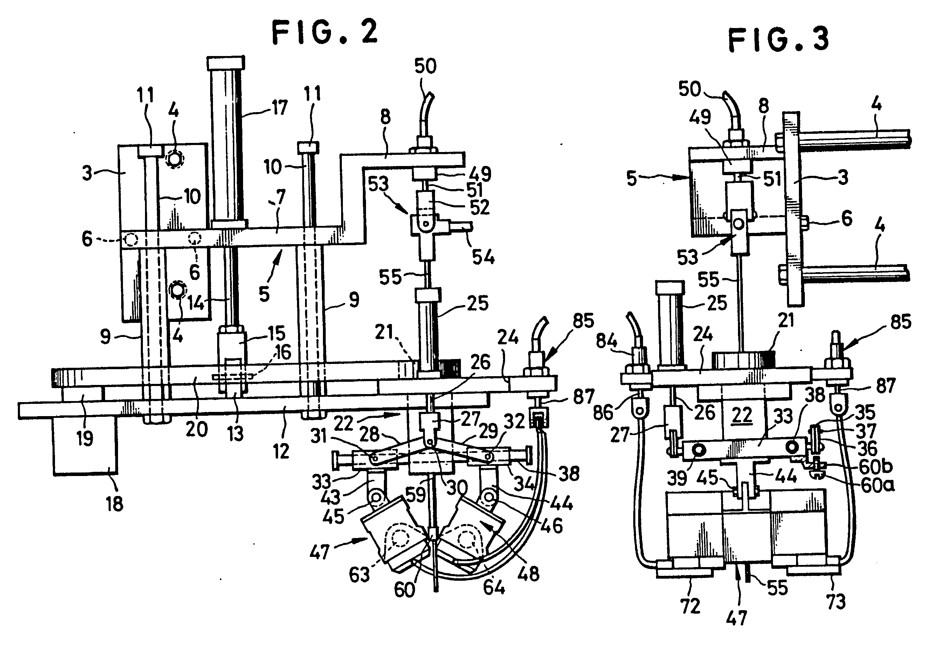

Figure 2 shows an embodiment of the apparatus according to the present invention in a front view. The apparatus has a vertical support 3 fixed to the apparatus by fixing bolts 4, 4. On one side (left side in Figure 3) of the vertical support 3, a bracket 5 is arranged integrally by screw bolts 6, 6. The bracket 5 has a longer supporting part 7 and a shorter supporting part 8. On the underside of the longer supporting part 7 are fixed guide sleeves 9, 9 by, for example, screwing their upper ends thereinto. Inside the guide sleeves is inserted each a guide rod 10 so as to allow vertical movement. Each guide rod 10 has a stopper 11 at its upper end. The guide rods 10 are held at the lower ends thereof on a holder table 12. A connection lug 13 is arranged on the upper face of the holder table 12 and serves for connecting with a piston rod 14 of a cylinder/piston arrangement 17 by a split shank 15 with a connection pin 16. The piston rod 14 performs a vertical movement by a cylinder/piston arrangement 17 operating in a hydraulic or pneumatic principle. The holder table 20 carries a driving means consisting of, such as, an air rotary actuator. The driving movement of the driving means 18 is transmitted to a rotatable shaft 22 by a belt/pulley transmission means (19,20). The rotatable shaft 22 is held rotatably inserted in a bearing hole 23 disposed in the holder table 12. The rotatable shaft 22 is provided at its upper end with an upper supporting plate 24 on which a cylinder/piston actuator 25 operating in a hydraulic or pnewmatic principle for effecting the adjustment of the distance of the pair of line focuses irradiating onto the corresponding pair of process lines. The piston rod 26 of the cylinder/piston actuator 25 is connected on a connection member 27 which is connected to this side to a link connection consisting of two links 28, 29 and a connection pin 30. Each of the links 28, 29 is connected on the other side to either one of a pair of slide members 33, 34 by a pivot joint 31, 32. The pair of slide members 33, 34 are further connected with each other on the other side by a link connection consisting of two links 35, 36 and a connection pin 37. The pair of slide members 33, 34 are guided at their end portions on a pair of guide rods 38, 39 slidably. The pair of guide rods 38, 39 are disposed fixedly in a parallel arrangement through (41, 42) a lower supporting plate 40 arranged at the lower end of the rotatable shaft 22. Each of the pair of slide members 33, 34 is provided on its underside an arm 43, 44. The arms 43, 44 carry each a heat ray source 47, 48 through a pivot joint 45, 46.

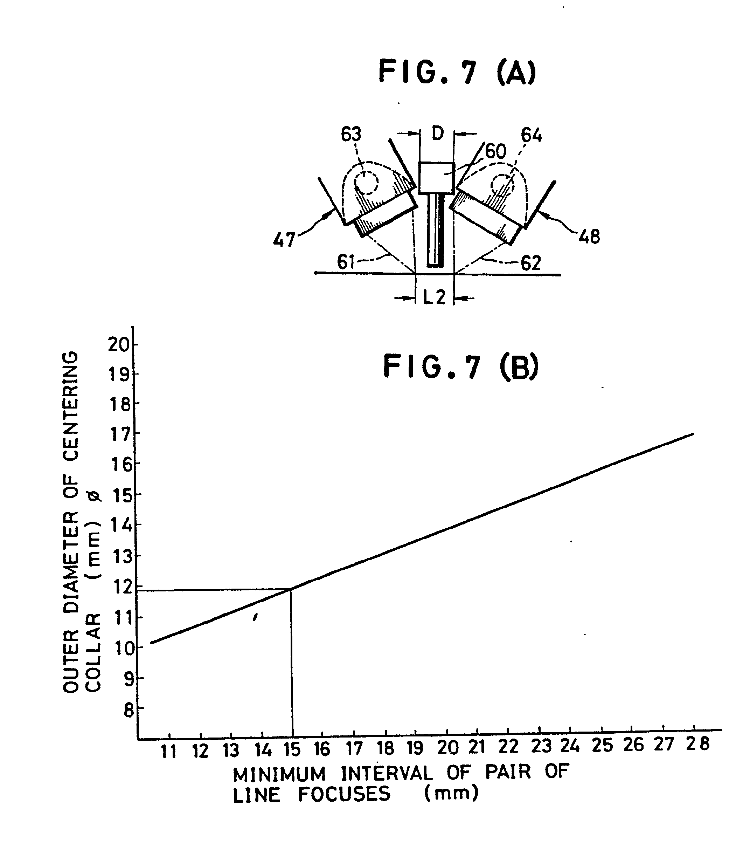

The shorter supporting part 8 of the bracket 5 carries a cylinder/piston unit 49 operated in a hydraulic or pneumatic principle which is connected to, for example, an air source (not shown) via a pipe 50. The piston rod 51 thereof is connected to a junction member 53 by a connection piece 52. The junction member 53 is connected on this side to an air pipe 54 through which, for example, cooling air from a cooling air source (now shown) is supplied. To the junction member 53 is further connected an arrester tube 55 at its upper end. The arrester tube 55 is constituted of, for example, a metal tube and extends through a penetrating hole 56 disposed at the center of the rotatable shaft 22 freely slidably up to a portion near the work piece. The lower end of the arresting tube 55 opens freely to allow discharge of the cooling air. It is possible that many slits are formed around the tube end periphery in an adequate uniform circumferential distribution so as to effect a uniform discharge of the cooling air around the tube end. The rotatable shaft 22 has at its lower end a threaded hole 58 (see Figure 5) in which a guide tube 59 is inserted by screwing therein. The arrester tube 55 is disposed penetrating the guide tube 59 freely movably. At the lower end of the guide tube 59, a centering collar 60 is attached removably which serves to settle the minimum distance between the pair of line focuses of heat ray beams 61, 62 emitted from the heat ray lamps 63, 64 of the pair of heat ray sources 47, 48. Therefore, various sizes of centering collars 60 having varying outer diameters are kept in preservation for optional use in accordance with each particular processing work. Thus, in a practical application of the apparatus according to the present invention, the distance between the pair of line focuses of heat ray beams is first let coincide to the distance $L_1$ between the pair of processing lines in the direction of x- co-ordinate, a suitable centering collar 60 can easily be chosen by reading the correlation diagram given in Figure 7. Thus, for example, if the distance $L_1$ between the pair of processing lines is assumed to be 15 mm, a suitable centering collar 60 should have an outer diamter $\varnothing$ of 11.8 mm. In order to settle the distance $L_2$ between the pair of processing lines in the direction of y- co-ordinate, the angle of directing the heat ray source to the processing line is adjusted by an adjusting screw 60a arranged so as to permit an adjustment of the travelling stroke of the screw in a support member 60b arranged on the lower supporting plate 40. The adjusting screw 60a is positioned directly under the connection pin 37 connecting the links 35 and 36 (see Figure 6). The lower edge of the links 35, 36 will abut onto the top of the adjusting screw 60a and thus offers limitation of the horizontal mutual shifting of the pair of slide members 33, 34 to thereby cause limitation of the maximum interval of the pair of heat ray sources 47, 48, so that the distance between the pair of line focuses of heat ray beams can be set to coincide with the distance $L_2$ between the pair of processing lines of y- direction.

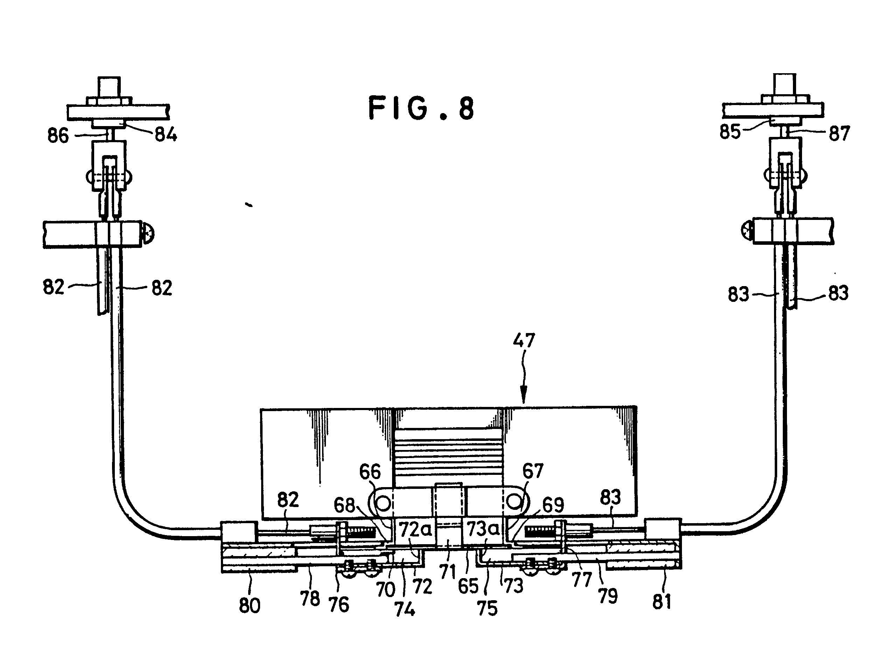

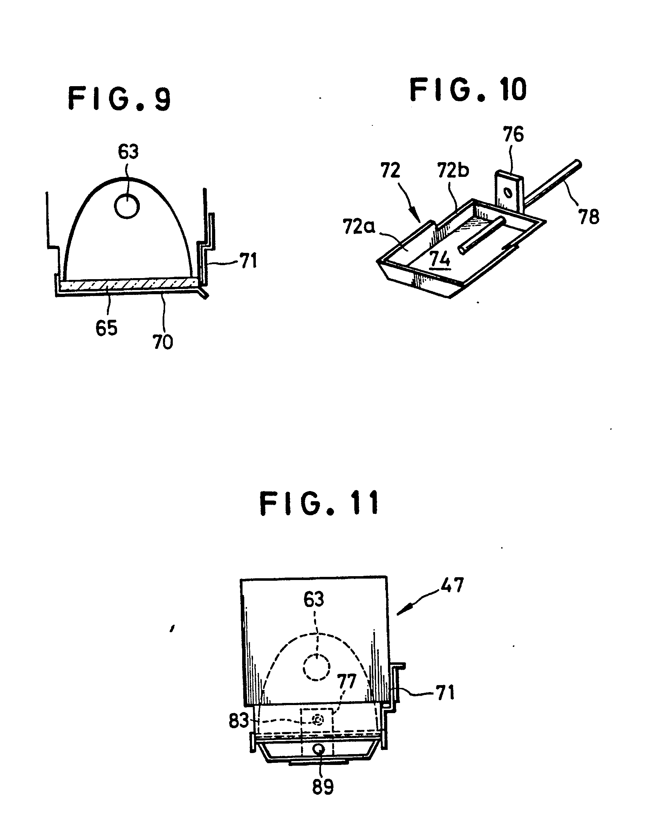

The heat ray sources 47, 48 are provided each with a heat ray lamp 63, 64 and a glass cover plate 65 made of a heat resistant glass, such as, quartz glass, Pyrex (trade name) or so on, over its heat ray discharging opening (see Figures 8 and 9). The heat resistant glass plate 65 is inserted removably along the receptacle part 68, 69 formed at the lower end of the reflecting side plates 66, 67 of the heat ray source by bending a portion thereof. The glass plate is supported on a supporting frame 70 extending over the entire width of the glass plate 65 on the underside of one the two receptacle parts 68.

The end portion on the entrance side of the supporting frame 70 is bent downwards a little, in order to ease the insertion of the glass plate 65 (refer to Figure 9). In order to prevent draw-out of the glass plate 65 so inserted, it is retained by a vertically slidable stopper 71 (see Figure 11) disposed on the heat ray source body. Since the structure of the heat ray source is the same for both the sources 47 and 48, the explanation thereof is directed hereinafter only to the heat ray source 47.

In order to limit the longitudinal extension of the heat ray beams and thus to limit the length of the line focus, the heat ray source is provided with a masking element consisting essentially of a pair of shield members 72, 73 disposed on the outer face of the heat resistant glass plate 65 slidably along it (see Figure 8). Each heat ray source has a pair of shield members 72, 73 each of which has peripheral rising hedges 72a, 73a surrounding it to form a heat ray shielding space 74, 75. A part of the surrounding hedges 72a is cut off (72b) so as to facilitate venting off of heat accumulated within the heat ray source. The longitudinal hedges are inclinedly formed (see Figure 10), in order to prevent substantial contact of the surrounding hedges 72a, 73a to the arrester tube 55, even if the pair of heat ray sources 47, 48 are positioned close to the minimum distance with each other (see Figure 2). Each of the pair of shield members 72, 73 is provided with a stopper block 76, 77 (Figures 8, 10). Through this stopper block 76, 77, a guide bar 78, 79 is inserted. The guide bar 78, 79 is coupled with a flexible actuation transmission wire 82, 83 which is connected at its other end to a piston rod 86, 87 of a cylinder/piston unit 84, 85 operating in a pneumatic principle. The cylinder/piston unit 84 is associated with the shield member 72 and the cylinder/piston unit 85 is associated with the shield member 73 (see Figure 2). Each shield member is further provided with a stopper screw 88, 89 which serves for limiting the shifting movement of the shield member 72, 73 by abutting thereto.

If the travelling stroke of the stopper screws 88, 89 is chosen to be small, the amount of shift of the pair of shield members 72, 73 becomes large and, thus, a longer line focus of the heat ray beam is attained, so that a longer processing length $1_2$ in the direction of x- co-ordinate can be adjusted in a simple manner. In a similar way, a shorter processing length $1_2$ in the direction of y- co-ordinate can be adjusted by setting the travelling stroke of the stopper screw at a correspondingly greater value.

The actual manner of operation of the apparatus according to the present invention is as follows :-

Each row of the terminal lead pins 1a, 1b of the semiconductor chip is aligned to the corresponding row of terminal lead pins 2a, 2b on the substrate plate 1 so as to align each terminal lead pin of the semiconductor chip to the corresponding terminal lead pin of the substrate. Then, the distance of the pair of line focuses of the heat ray beams and the length of the line focus is adjusted so as to coincide to those ($L_1$, $1_1$ and $L_2$, $1_2$) of the pair of processing lines. If, for example, the distance between the pair of processing lines of the direction of x- co-ordinate $L_1$ is assumed to be 19 mm, a centering collar 60 having an outer diameter of 13,5 mm $\varnothing$ should be chosen from the correlation diagram of Figure 7. This centering collar 60 is mounted on the guide tube 59 at its lower end.

Each of the pair of heat ray sources 47, 48 is tilted around the pivot joint 45 or 46, until the side edge of the heat ray source will abut onto the side face of the centering collar 60. In this same manner, the interval of the pair of parallel line focuses of the heat ray beams 61, 62 emitted from the pair of heat ray sources 47, 48 will coincide with the distance $L_1$ between the pair of parallel processing lines of the direction of x- co-ordinate. In order thereafter to adjust the length of the line focus so as to coincide with the processing length $1_1$ of x- direction, the travelling stroke of the stopper screw 88, 89 is settled correspondingly to determine the amount of shifting of the shield members 72, 73.

For adjusting the distance between the pair of line focuses so as to coincide with the distance $1_2$ between the pair of processing lines of y- direction, the travelling stroke of the adjusting screw 70a is correspondingly settled to adjust the position of contact with the links 35, 36, in order to limit correspondingly the articular spreading movement of the links 28, 29 to thereby attain coincidence of the distance between the pair of line focuses of the heat ray beams 61, 62 with said distance $L_2$ between said pair of processing lines.

Likewise, for attaining adjustment of the processing length $1_2$ in the direction of y- co-ordinate, the travelling stroke of the stopper screw 88, 89 is settled correspondingly so as to attain a suitable adjustment of the width of heat ray discharging opening to thereby reach a suitable length of the line focus corresponding to the requisite processing length $1_1$ in the direction of y- co-ordinate.

In carrying out soldering of a semiconductor chip on a substrate, the pneumatic cylinder/piston unit 49 is operated to let descend the arrester tube 55 until the lower end thereof will touch the semiconductor chip 2 at the center thereof to pressingly arrest the work piece in a suitable condition. Then the cylinder/piston arrangement 17 is actuated so as to cause the piston rod 14 to descend to lower the heat ray source assembly to a position at which the heat ray beams 61, 62 from the heat ray lamp 63, 64 will be focussed onto the pair of processing lines extending parallel in the direction of x- co-ordinate with a processing length $1_1$ and the distance $L_1$ between them, in a pair of line focuses having a corresponding length and a corresponding distance between them. The soldering is effected by irradiating the processing lines by said pair of heat ray beams focussed onto them.

After the finish of the processing in the direction of x- co-ordinate, cooling air is supplied through the arrester tube 55 to blow onto the upper face of the work piece. At the same time, the holder table 20 is elevated by actuating the cylinder/piston arrangement 17 and, then, the heat ray source assembly is turned by 90° by operating the turning element. Thus, the driving means 18 is energised to rotate the pulley means 19, 21 via the belt 20 to cause rectangular turning of the assembly. In order to adjust the distance between the pair of line focuses so as to coincide with the distance $L_2$ between the pair of processing lines, the cylinder/piston actuater 25 is energised to cause the piston rod 26 to protrude so as to slide the slide members 33, 34 on the guide rods 38, 39 through the links 28, 29 to effect a parallel shifting of the slide members in the opposited direction with each other. This spreading movement is limited by abutment of the links 28, 29 onto the adjusting screw 60a, whereby a distance between the pair of line focuses corresponding to the distance $L_2$ between the pair of processing lines is settled. In order to adjust the processing length $1_2$, the cylinder/piston units 84, 85 disposed on the upper supporting plate is actuated, so as to cause simultaneous sliding of the shield members 72, 73 in the direction of approach with each other, whereby a length of the line focus corresponding to that of processing line in the direction of y- co-ordinate is attained. The above described movement of each part of the apparatus is started upon the finish of the processing work in the direction of x- co-ordinate at the same time with the starting of elevation of the heat ray source assembly and will be finished till the commencement of the processing work in the direction of y- co-ordinate. After the heat ray source assembly has been set for the processing of y- direction, the heat ray source assembly is caused to descend by the cylinder/piston arrangement 17 in the same manner as explained above to realise the irradiation of the pair of processing lines by focussing the heat ray beams threonto to effect soldering within a moment. Thereafter, the blowing of the cooling air from the arrester tube 55 onto the work piece and the lifting of the heat ray source assembly are accomplished in the same manner as explained above. The supply of cooling air is then stopped and the arrester tube 55 is lifted by the action of the pneumatic cylinder/piston unit 49. In this manner, one complete cycle of the processing work inclusive of processing steps of x- and y- directions is completed.

It is of couse possible to employ the apparatus only for the processing of only one direction, namely, in x- or y- co-ordinate.

## Claims

1. Apparatus for processing a work piece by irradiating a pair of coplanar parallel processing lines with heat rays characterised in that it comprises : heat ray source means (47,48) mounted on a heat ray source assembly and means for focussing the heat rays into lines on said processing lines ; means (17,22) for moving the work piece and heat ray source means towards and away from each other so as to bring the work piece into and out of the focus of the heat rays and to effect relative rotation of the heat ray source means (47,48) and work piece to allow the processing of further processing lines extending in different directions to the first mentioned processing lines; means (25,39) for adjusting the distance between the parallel line foci of the heat rays ; and an adjustable masking element (12,73) disposed between the heat ray source means (47,48) and the work piece to vary the width of the beam of heat rays thereby to determine the length of the line focus of the heat rays.

2. An apparatus according to claim 1, characterised in that the heat ray source means (47,48) comprises a pair of heat ray lamps pivotally mounted on the heat ray source assembly, in that the heat ray source assembly is rotatable, and in that the distance between the parallel line foci is adjusted by effecting a relative shifting of the heat ray lamps.

3. An apparatus according to claim 1 or 2, characterised in that the masking element comprises two slidable shield members (72,73).

4. Apparatus according to claim 3, characterised in that each shield member (72,73) of the masking element is slidably guided on a guide bar (78,79) along the heat ray discharge opening of the heat ray source, and has a configuration of an approximately rectangular dish surrounded by peripheral rising hedges (72a, 73a), of which a pair of longitudinal hedges have a partial cut off portion (72b) to facilitate venting out of the heat accumulated within the heat ray source.

5. An apparatus according to claim 4, characterised in that the opposing rising hedges (72a, 73a) of the pair or each shield member (72, 73) are inclined to each other.

6. An apparatus according to any one of the preceding claims, characterised in that the heat ray source assembly is rotatably supported on a holder table (12) so constructed to allow vertical displacement of the heat ray source means relative to the work piece.

7. An apparatus according to claim 6, characterised in that the heat ray source assembly is attached to a rotatable shaft (22) said shaft being supported rotatably in a bearing hole (23) formed in the holder table (12) provided at its upper end with a pulley (21) connected via a belt (20) to a driving means (19) arranged on the holder table.

8. An apparatus according to claim 7, characterised in that the heat ray source assembly has at the lower end of the rotatable shaft (22) a lower support plate (40) supporting a pair of parallel guide rods (38,39) having mounted thereon a pair of sliding members (33,34), the pair of sliding members (33,34) being connected, to a further cylinder/piston acutator (25) via a link connection (26,27,28,29) and to the pair of heat ray sources so as to allow adjustment of the distance between the pair of parallel line foci.

9. An apparatus according to claim 8, characterised in that the pair of sliding members (33,34) are connected with each other by a further link connection (35,36), the articular movement of which is limited by a stopper comprising an adjustment screw (60a) disposed on said lower supporting plate (40).

10. An apparatus according to any one of claims 1 to 9, characterised in that the heat ray source is provided at its heat ray discharge opening with a heat resistant glass plate (65) which is guided and supported by an arresting member (70) fixed to the heat ray source means and has a portion bent downwards at the entrance end thereof, and is retained by a vertically slidable stopper (71) disposed on the heat ray source body.

11. An apparatus according to claim 3, 4 or 5, characterised in that a stopper block (76) is fixedly disposed on the or each shield member (72,73) of the masking element to limit the sliding movement of the or each shield member by abutting onto a stopper screw (88,89) adjustably fixed to the heat source lamp so as to allow variation of the travelling distance of the or each shield member (72,73).

12. An apparatus for processing a work piece, characterised in that it comprises a pair of heat ray sources (47,48), arranged on a heat ray source assembly, for irradiating a pair of parallel processing lines by focussing heat rays into lines along said processing lines, said heat ray source assembly being rotatable so as to allow said line foci to be aligned with processing lines extending in a different direction to the first lines, a cylinder/piston arrangement (14,17) for effecting vertical positioning of said pair of heat ray sources (47,48) for adjusting the focussing of the heat rays onto said processing line, a distance adjusting (25,39) means for adjusting the distance between said pair of parallel line foci by effecting a relative shifting of said pair of heat ray sources (47,48), a masking element (72,73) provided for each heat ray source (47,48) and comprising a shield member (72,73) for defining the width of the heat ray beam leaving the heat ray source (47,48) and thereby determining the length of the line focus and masking element actuating means provided for each of said pair of heat ray sources and comprising at lest one cylinder/piston unit for effecting shifting of said shield member to vary the width of the heat ray beam and thus to vary the length of the line focus.

## Ansprüche

1. Vorrichtung zur Behandlung eines Werkstücks durch Bestrahlung eines Paares von koplanaren parallelen Behandlungslinien mit Wärmestrahlen, **gekennzeichnet durch**
eine Wärmestrahlenquelle (47, 48), die an einer Wärmestrahlenquellenstruktur angeordnet ist und eine Einrichtung zum Fokussieren der Wäremstrahlen in Linien auf den Behandlungslinien aufweist, eine Einrichtung (17, 22) zum Bewegen des Werkstückes und der Wärmestrahlenquelle aufeinander zu und voneinander weg, um das Werkstück in den Brennpunkt der Wärmestrahlen und aus ihm herauszubringen und eine relative Rotation zwischen der Wärmestrahlenquelle (47, 48) und dem Werkstück zu bewirken, um die Behandlung von weiteren Behandlungslinien zu ermöglichen, die sich in Richtungen erstrecken, die von den zuerst genannten Behandlungslinien verschieden sind, eine Einrichtung (25, 39) zum Einstellen des Abstandes zwischen den Brennpunkten der parallelen Linien der Wärmestrahlen, und durch ein einstellbares Maskierungselement (12, 73), das zum Variieren der Strahlenbreite der Wärmestrahlen und damit zum Bestimmen der Länge des Linienbrennpunktes der Wärmestrahlen zwischen der Wärmestrahlenquelle (47, 48) und dem Werkstück angeordnet ist.

2. Vorrichtung nach Anspruch 1,
**dadurch gekennzeichnet,**
dass die Wärmestrahlenquelle (47, 48) ein Paar Wärmestrahlenlampen aufweist, die an der Wärmestrahlenquellenstruktur schwenkbar angeordnet sind, dass die Wärmestrahlenquellenstruktur drehbar ist, und dass der Abstand zwischen den Brennpunkten der parallelen Linien durch die Ausführung eines relativen Verstellung der Wärmestrahlenlampen eingestellt wird.

3. Vorrichtung nach Anspruch 1 oder 2,
**dadurch gekennzeichnet,**
dass das Maskierungselement zwei verschiebbare Schildelemente (72, 73) aufweist.

4. Vorrichtung nach Anspruch 3,
**dadurch gekennzeichnet,**
dass jedes Schildelement (72, 73) des Maskierungselementes an einer Führungsstange (78, 79) entlang der Wärmestrahlen-Ausgabeöffnung der Wärmestrahlenquelle verschiebbar geführt ist und eine Ausbildung einer annähernd rechteckigen Scheibe besitzt, die von Randerhöhungen (72a, 73a) umgeben ist, von denen ein Paar von länglichen Erhöhungen ein unvollständiges Ausschnitteil (72b) zum Erleichtern der Entlüftung der innerhalb der Wärmestrahlenquelle gesammelten Wärme besitzen.

5. Vorrichtung nach Anspruch 4,
**dadurch gekennzeichnet,**
dass die gegenüberliegenden Erhöhungen (72a, 73a) des Paares von Schildelementen oder jedes Schildelementes (72, 73) zueinander geneigt sind.

6. Vorrichtung nach einem der vorhergehenden Ansprüche,
**dadurch gekennzeichnet,**
dass die Wärmestrahlenquellenstruktur an einem Haltetisch (12) drehbar gehalten ist, der derartig ausgebildet ist, dass eine vertikale Verstellung der Wärmestrahlenquelle relativ zum Werkstück möglich ist.

7. Vorrichtung nach Anspruch 6,

**dadurch gekennzeichnet,**
dass die Wärmestrahlenquellenstruktur an einer drehbaren Welle (22) angebracht ist, wobei die Welle in einem im Haltetisch (12) ausgebildeten Lagerloch (23) drehbar gelagert und an ihrem oberen Ende mit einem Rad (21) versehen ist, das über einen Riemen (20) mit einer am Haltetisch angeordneten Antriebseinrichtung (19) verbunden ist.

8. Vorrichtung nach Anspruch 7, **dadurch gekennzeichnet, dass die Wärmestrahlenquellenstruktur am unteren Ende der drehbaren Welle (22) eine untere Halteplatte (40) besitzt, die ein Paar von parallelen Führungsstangen (38, 39) trägt, an denen ein Paar Gleitelemente (33, 34) angeordnet sind, wobei das Paar Gleitelemente (33, 34) über eine Gelenkverbindung (26, 27, 28, 29) an einen weiteren Zylinder/Kolben-Antrieb (25) und an das Paar von Wärmestrahlenquellen angeschlossen ist, um eine Einstellung des Abstandes zwischen dem Paar paralleler Linienbrennpunkte zu ermöglichen.

9. Vorrichtung nach Anspruch 8, **dadurch gekennzeichnet,**
dass das Paar von Gleitelementen (33, 34) miteinander mittels einer weiteren Gelenkverbindung (35, 36) verbunden sind, deren Bewegung durch einen Stopper begrenzt ist, der eine Einstellschraube (60a) aufweist, die an der unteren Halteplatte (40) angeordnet ist.

10. Vorrichtung nach einem der Ansprüche 1 bis 9, **dadurch gekennzeichnet, dass die Wärmestrahlenquelle an ihrer Wärmestrahlen-Ausgabeöffnung mit einer temperaturbeständigen Glasplatte (65) versehen ist, die geführt und gehalten ist durch ein Festlegeelement (70), das an der Wärmestrahlenquelle befestigt ist und einen Abschnitt besitzt, der am Einlassende nach unten gebogen ist, und die durch einen vertikal verstellbaren Stopper (71) festgehalten wird, der am Körper der Wärmestrahlenquelle angeordnet ist.

11. Vorrichtung nach einem der Ansprüche 3, 4 oder 5, **dadurch gekennzeichnet,**
dass an dem oder an jedem Schildelement (72, 73) des Markierungselementes ein Stopperblock (76) starr angeordnet ist zum Begrenzen der Verstellbewegung des oder jedes Schildelementes durch Anschlag an einer Stopperschraube (88, 89), die an der Wärmequellenlampe einstellbar befestigt ist, um eine Veränderung des Verstellabstandes des oder jedes Schildelementes (72, 73) zu ermöglichen.

12. Vorrichtung zur Behandlung eines Werkstückes **gekennzeichnet durch**
ein Paar von Wärmestrahlenquellen (47, 48), die an einer Wärmestrahlenquellenstruktur angeordnet sind zur Bestrahlung eines Paares von parallelen Behandlungslinien durch Fokussierung von Wärmestrahlen in Linien entlang den Behandlungslinien, wobei die Wärmestrahlenquellenstruktur drehbar ist, damit die besagten Linienbrennpunkte mit Behandlungslinien fluchten, die sich in einer von den ersten Linien verschiedenen Richtung erstrecken, eine Zylinder/Kolben-Anordnung (14, 17) zur vertikalen Anordnung des Paares von Wärmestrahlenquellen (47, 48) zur Einstellung der Fokussierung der Wärmestrahlen auf die Behandlungslinien, eine Abstandseinstelleinrichtung (25, 39) zum Einstellen des Abstandes zwischen dem Paar von parallelen Linienbrennpunkten durch die Ausführung einer relativen Verschiebung des Paares von Wärmestrahlenquellen (47, 48), ein Maskierungselement (72, 73) für jede Wärmestrahlenquelle (47, 48), das ein Schildelement (72, 73) aufweist zur Festlegung der Breite des Wärmestrahles, der die Wärmestrahlenquelle (47, 48) verlässt und dadurch die Länge des Linienbrennpunktes bestimmt, und durch eine Betätigungseinrichtung für ein Maskierungselement, die für jede Wärmestrahlenquelle des Wärmestrahlenquellen-Paares vorgesehen ist und mindestens eine Zylinder/Kolben-Einheit zur Verstellung des Schildelementes zum Verändern der Breite des Wärmestrahles und folglich zum Verändern der Länge des Linienbrennpunktes aufweist.

## Revendications

1. Appareil pour traiter une pièce en irradiant deux lignes de traitement parallèles disposées dans le même plan avec des rayons thermiques, caractérisé en ce qu'il comprend : des moyens de sources de rayons thermiques (47, 48) montés sur un ensemble de sources de rayons thermiques et des moyens pour focaliser les rayons thermiques selon des lignes sur les lignes de traitement ; des moyens (17, 22) pour déplacer la pièce et les moyens de sources de rayons thermiques pour les rapprocher et les éloigner l'une des autres afin d'amener la pièce sur le foyer des rayons thermiques et pour l'en sortir et pour effectuer la rotation relative des moyens de sources de rayons thermiques (47, 48) et de la pièce afin de permettre de traiter d'autres lignes de traitement s'étendant dans des directions différentes des lignes de traitement mentionnées en premier ; des moyens (25, 39) pour régler la distance entre les lignes focales parallèles des rayons thermiques, et un élément de masquage réglable (72, 73) disposé entre les moyens de sources de rayons thermiques (47, 48) et la pièce pour faire varier la largeur du faisceau de rayons thermiques et déterminer ainsi la longueur de la ligne focale des rayons thermiques.

2. Appareil selon la revendication 1, caractérisé en ce que les moyens de sources de rayons thermiques (47, 48) comportent deux lampes à rayonnement thermique montées à pivotement sur l'ensemble de sources de rayons thermiques, en ce que l'ensemble de sources de rayons thermiques peut pivoter et en ce que la distance entre les lignes focales parallèles est réglée en effectuant un déplacement relatif des lampes à rayonnement thermique.

3. Appareil selon la revendication 1 ou la revendication 2, caractérisé en ce que l'élément de masquage comprend deux écrans coulissants (72, 73).

4. Appareil selon la revendication 3, caractérisé en ce que chaque écran (72, 73) de l'élément de masquage est guidé à coulissement sur une barre de guidage (78,79) le long de l'ouverture de sortie des rayons thermiques de la source de rayons thermiques et a la forme d'une cuvette sensiblement rectangulaire entourée par des bords relevés périphériques (72a, 73a), les deux bords relevés longitudinaux ayant une portion découpée partiellement (72b) pour faciliter l'évacuation de la chaleur accumulée à l'intérieur de la source de rayons thermiques.

5. Appareil selon la revendication 4, caractérisé en ce que les bords relevés opposés (72a, 73a) de chaque écran (72, 73) sont inclinés l'un par rapport à l'autre.

6. Appareil selon l'une quelconque des revendications précédentes, caractérisé en ce que l'ensemble de sources de rayons thermiques est supporté en rotation sur une table support (12) réalisée de façon à permettre le déplacement vertical des moyens de sources de rayons thermiques par rapport à la pièce.

7. Appareil selon la revendication 6, caractérisé en ce que l'ensemble de sources de rayons thermiques est fixé sur un arbre tournant (22), cet arbre étant supporté en rotation dans un trou de palier (23) formé dans la table support (12) et équipé à son extrémité supérieure d'une poulie (21) reliée par une courroie (20) à un moyen d'entrainement (19) disposé sur la table support.

8. Appareil selon la revendication 7, caractérisé en ce que l'ensemble de sources de rayons thermiques a, au niveau de l'extrémité inférieure de l'arbre tournant (22), une plaque support inférieure (40) supportant deux tiges de guidage parallèles (38, 39) sur lesquelles sont montés respectivement deux éléments coulissants (33, 34), les deux éléments coulissants (33, 34) étant reliés à un autre vérin (25) par l'intermédiaire d'une transmission par bielles (26, 27, 28, 29) et aux deux sources de rayons thermiques de façon à permettre de régler la distance entre les deux lignes focales parallèles.

9. Appareil selon la revendication 8, caractérisé en ce que les deux éléments coulissants (33, 34) sont reliés l'un à l'autre par une autre transmission par bielles (35, 36) dont le mouvement de pivotement est limité par une butée constituée par une vis de réglage (60a) disposée sur la plaque support inférieure (40).

10. Appareil selon l'une quelconque des revendications 1 à 9, caractérisé en ce que la source de rayons thermiques est équipée, au niveau de son ouverture de sortie des rayons thermiques, d'une plaque de verre résistant à la chaleur (65) qui est guidée et supportée par un élément d'arrêt (70) fixé sur les moyens de sources de rayons thermiques et qui a une portion courbée vers le bas à son extrémité d'entrée, et est retenue par une butée pouvant coulisser verticalement (71) disposée sur le corps de la source de rayons thermiques.

11. Appareil selon l'une des revendications 3, 4 ou 5, caractérisé en ce qu'un bloc de butée (76) est fixé sur le ou chaque écran (72, 73) de l'élément de masquage pour limiter le mouvement de coulissement du ou de chaque écran par la venue en butée sur une vis de butée (88, 89) fixée de façon réglable sur la lampe de la source de rayons thermiques de façon à permettre de faire varier la distance du trajet du ou de chaque écran (72, 73).

12. Appareil pour traiter une pièce, caractérisé en ce qu'il comporte deux sources de rayons thermiques (47, 48), disposées sur un ensemble de sources de rayons thermiques, pour irradier deux lignes de traitement parallèles en focalisant des rayons thermiques en des lignes sur les lignes de traitement, l'ensemble de sources de rayons thermiques pouvant pivoter de façon à permettre d'aligner les lignes focales sur des lignes de traitement s'étendant dans une direction différente des premières lignes de traitement, un vérin (14, 17) pour positionner verticalement les deux sources de rayons thermiques (47, 48) pour régler la focalisation des rayons thermiques sur les lignes de traitement, des moyens de réglage de distance (25, 39) pour régler la distance entre les deux lignes focales parallèles en effectuant un déplacement relatif des deux sources de rayons thermiques (47, 48), un élément de masquage (72, 73) prévu pour chaque source de rayons thermiques (47, 48) et comportant un écran (72, 73) pour définir la largeur du faisceau de rayons thermiques quittant la source de rayons thermiques (47, 48) en déterminant ainsi la longueur de la ligne focale, et des moyens d'actionnement de l'élément de masquage prévus pour chaque source de rayons thermiques et comprenant au moins un vérin pour déplacer l'écran afin de faire varier la largeur du faisceau de rayons thermiques et faire varier ainsi la longueur de la ligne focale.

# F I G. 1

# FIG. 2

# FIG.3

EP 0 209 390 B1

# FIG. 4

# FIG. 5

# FIG. 6

# FIG. 7 (A)

# FIG. 7 (B)

OUTER DIAMETER OF CENTERING COLLAR ⌀ (mm)

MINIMUM INTERVAL OF PAIR OF LINE FOCUSES (mm)

# FIG.8

FIG.9

63

71

65

70

FIG.10

76

72

72b

72a

74

78

FIG.11

63

47

77

71

83

89

# FIG.12

76  77

88  89

# FIG. 13

19  20  35  34  21  28
18  37  29
36  39  33  38